# EUROPEAN PATENT APPLICATION

(11) **EP 2 200 073 A1**
(43) Date of publication of application: **23.06.2010**
(21) Application number: 08777011.1
(22) Date of filing: 30.05.2008
(51) Int. Cl.: H01L 21/28, H01L 21/285, H01L 21/304

(54) **METHOD FOR FORMING SILICIDE AND APPARATUS FOR FORMING THE SILICIDE**

(71) Applicant: Canon Anelva Corporation, Asao-ku Kawasaki-shi Kanagawa 215-8550 (JP)
(72) Inventor: SEINO, Takuya, Kawasaki-shi Kanagawa 215-8550 (JP); IKEMOTO, Manabu, Kawasaki-shi Kanagawa 215-8550 (JP); MASHIMO, Kimiko, Kawasaki-shi Kanagawa 215-8550 (JP)
(74) Representative: Musker, David Charles
(86) International application number: PCT/JP2008/060000
(87) International publication number: WO 2009/144810

(57) **Abstract**

Radical in a plasma generation chamber is supplied to a process chamber through an introducing aperture, and HF gas is supplied as a process gas from the vicinity of the radical introducing aperture. A native oxide film of the substrate surface of a IV group semiconductor doped an impurity is removed, with a good surface roughness equal to the wet cleaning. The substrate after the surface treatment is deposited with a metal material and metal silicide formation by thermal treatment is performed, and during these processes, the substrate is not exposed to the atmosphere, and a good contact resistance equal to or better than the wet process is obtained.

## Description

### TECHNICAL FIELD

The present invention relates to a unit for performing surface treatment for a IV group semiconductor surface or a IV group semiconductor surface doped the impurity in a silicide formation process and a manufacturing method thereof, and in particular, it relates to a method of forming a metal silicide layer.

### BACKGROUND ART

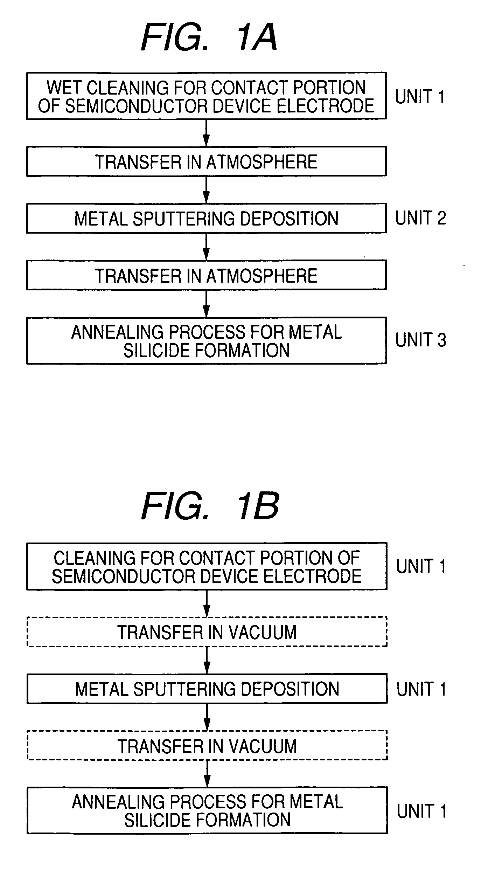

Accompanied with high density and high integration of a semiconductor device, the multilayered wiring structure has been advanced, and a forming technique that electrically connects the semiconductor device with an electrode in a low resistance has become important. As a commonly used forming technique of the electrode, sputtering or chemical vapor deposition of the metal material such as Al and W are employed. However, a contact resistance between the metal and a semiconductor junction portion has become non-negligible, and to make the contact resistance into a low resistance, a technique that forms a metal silicide layer in the electrode portion has become necessary. Further, in the surface IV group semiconductor doped the impurity such as B, P and As, there arises a problem that re-oxidation and roughness of the surface after the surface cleaning deteriorate by depending on the impurity concentration due to the difference in binding energy. In the method shown in FIG. 1A, the metal silicide film is formed in such a manner that a native oxide film on a silicon wafer is removed by wet cleaning, and after that, a metal material is grown, and heat treatment (annealing) for metal silicification is performed. The native oxide film of the surface of the IV group semiconductor is formed during the transfer of the substrate and various processes, and therefore, it is difficult to completely prevent the native oxide film.

Residual of this native oxide film not only hinders the formation of the metal silicide, but also deteriorates the electric characteristics of the contact portion. Hence, prior to each process, it is necessary to remove this native oxide film. However, accompanied with the micronization of the semiconductor device, a size of the element becomes small, and this has caused a problem that the native oxide film cannot be removed due to complete removal of a water mark at the drying time and an inability of medicals to reach the oxide film formed at the bottom of a minute hole. Further, after the wet cleaning of the silicon wafer, when moving to the next processing, though it is inevitably exposed to the atmosphere, at this time, the surface is formed again with the native oxide film, and is stuck fast again with carbon atoms. Hence, prior to the deposition which is the next process, an UHF vacuum heating of 750°C or more or heating of 800°C or more in a H₂ atmosphere are performed, thereby the oxide film of the surface has been removed. However, when the micronization of the device advances and the metal electrode and the metal silicide are used, there arises a problem that high temperature processing prior to the deposition increases the deposition temperature, and causes a characteristic change of the metal material. For example, when the metal material is deposited by the substrate temperature of approximately 300°C, a film quality is greatly changed as compared with the case where the deposition is performed at the low temperature of an approximately room temperature, and after that, even when silicide formation is performed by annealing, the film quality of a desired characteristic cannot be obtained. In this manner, since it is necessary to deposit the metal material at much lower temperature, when the high temperature processing has been carried out prior to the deposition, it is necessary to perform the next deposition of the metal material after the substrate temperature is sufficiently lowered. For this reason, a specific cooling unit and the time for cooling are required, and this creates a problem that the processing time is long and the cost on the device production is increased.

Consequently, the wet cleaning is limited, and as shown in FIG. 1B, a dry cleaning that performs deposition pretreatment of the semiconductor substrate in vacuum is required. As compared with FIG. 1A, this eliminates an atmospheric transfer, and makes a vacuum transfer, and by performing the prior art three processes by one unit, it is possible to suppress impurity adsorption and shorten the processing time. As the pretreatment that removes the native oxide film of the IV group semiconductor surface when forming the metal silicide layer, Japanese Patent Application Laid-Open No. 2001-274111 proposes a chemical plasma cleaning using a reactive gas. However, if the gas is turned into plasma, since it not only contains a radicalized fluorine gas, but also contains an ionized fluorine gas, when the native oxide film of the substrate surface is removed, etching advances up to the substrate surface, thereby causing a problem that unevenness arises on the surface.

Further, Japanese Patent Application Laid-Open No. 2006-294861 proposes that the native oxide is chemically modified into (NH4)₂SiF₆, and the substrate temperature is raised so that the modified film is removed, and further, the residual modified film is physically subjected to physical etching by Ar reverse sputtering. However, since the Ar reverse sputtering physically performs the etching, it is considered that a Si-Si bond of the substrate surface is also disconnected. In this case, the defects in Si are immediately formed with the oxide film, and non-coupled hands of Si are easily adsorbed with contaminated materials. Hence, a problem of damages to the device arises. Further, because two modules are used, it takes a long time before the silicide is formed.

In the prior art that forms a metal silicide layer on an electrode portion, the following problems are found in the pretreatment that deposits a metal material on a substrate surface. After the wet cleaning, since an atmospheric transfer is accompanied up to a process of depositing a metal material, an atmospheric component is absorbed into the substrate surface, and impurities such as the native oxide film and carbon atoms remain on the interface. This not only inhibits the formation of the metal silicide, but also increases the contact resistance. Hence, it is necessary to strictly manage the transfer time after the cleaning. On the other hand, in the chemical plasma and physical plasma cleaning, since etching advances not only to the native oxide film, but also to the substrate surface, there is a problem that the contact resistance causing unevenness on the surface is not sufficiently reduced. To sufficiently reduce the contact resistance, surface roughness is preferably approximately 0.5 nm or less. Further, in the surface where the impurities such as B, P, and As are doped on a IV group semiconductor, there is a problem that the re-oxidation and roughness of the surface after the surface cleaning deteriorate due to dependency on the impurity concentration. Further, since the forming process of the metal silicide film is easily affected by the temperature, when substrate heating is used for the removal of the native oxide film prior to the pre-deposition, the deposition temperature of the metal material is increased, and this causes a problem that the diffusion and composition change of the metal material occur and the metal silicide film having the desired characteristic is not obtained. Further, when the substrate heating is used for the removal of the native oxide film prior to the deposition, if an attempt is made to reduce the deposition temperature of the metal material in order to obtain the metal silicide film having the desired characteristic, a problem arises that a cooling unit or a plurality of processes such as a cooling time are required, and the processing time becomes long and the cost on the device production is increased. The present invention has been made in order to solve the above described problems.

### DISCLOSURE OF THE INVENTION

According to the result of the study conducted by the present inventors, it was found that radicals generated by the plasma are introduced into a process chamber from a plurality of holes provided on a partition plate that separates a plasma generation chamber and the process chamber, and by mixing the radicals with the process gas introduced separately into the process chamber, excitation energy of the radicals is suppressed, and thereby, the surface treatment of the substrate having a IV group semiconductor material doped the impurity such as Si or B or P, and high selectivity can be performed, so that the roughness of the substrate surface equal to or better than the wet cleaning is obtained, and the surface treatment that removes the native oxide film and the organic substance can be performed. Further, when the IV group semiconductor is doped (doped with) the impurity such as B, P, and As, by using the vacuum transfer that is not possible in the case of the wet cleaning, re-oxidation on the surface can be suppressed. The present invention uses a substrate cleaning method, which comprises: installing a substrate inside the process chamber; turning a plasma generation gas into plasma; introducing radical in the plasma into the process chamber through a radical introducing aperture of a plasma confinement electrode plate for plasma isolation; introducing a process gas into the process chamber and mixing it with the radical inside the process chamber; and cleaning the substrate surface by mixed atmosphere with the radical and the process gas.

Further, this is a substrate cleaning method, in which the surface of the substrate is a IV group semiconductor material, and the plasma generation gas and the process gas contain HF. Further, this is a substrate cleaning method in which the plasma confinement electrode plate for plasma isolation has a plurality of radical introducing apertures for introducing radicals in the plasma into the process chamber and a plurality of process gas introducing apertures for introducing the process gas into the process chamber, and the radical and the process gas are discharged to the substrate surface inside the process chamber from the respective introducing apertures. Further, the IV group semiconductor substrate surface is cleaned in a cleaning chamber by the above described substrate cleaning method, and without exposing the cleaned substrate to the atmosphere from the cleaning chamber, it is transferred to a metal film sputtering chamber through a transfer chamber, and the metal film is sputter-grown on the substrate surface inside the metal film sputtering chamber. This is a method comprising: transferring the substrate having the metal sputtering film manufactured by the above described substrate cleaning method from a metal film sputtering chamber to an annealing chamber through the transfer chamber without being exposed to the atmosphere, and modifying the metal film at the annealing chamber.

The method in accordance with the present invention is a method of forming a metal silicide layer on a substrate surface made of a IV semiconductor material doped an impurity such as B or P or As, and comprises: turning a plasma generation gas containing HF into plasma inside the plasma generation chamber; selectively introducing radical in the plasma into the cleaning chamber from the plasma generation chamber, and at the same time, introducing a process gas containing an unexcited HF in a gas ratio of 0.6 0r more into the cleaning chamber thereby cleaning the substrate in the mixed atmosphere of the radical and the process gas; transferring the cleaned substrate from the cleaning chamber to a sputtering chamber without the cleaned substrate being exposed to the atmosphere, and growing a metal sputtering layer made of a metal material on the cleaned substrate surface inside the sputtering chamber; and transferring the substrate having the metal sputtering layer from the sputtering chamber to an annealing chamber without the substrate being exposed to the atmosphere, and modifying the metal sputtering layer of the substrate surface into silicide by heating thereon inside the annealing chamber.

The roughness of the substrate surface after the cleaning is 0.5 nm or less, which is equal to or better than the wet cleaning. The metal sputtering layer is a noble metal, a semi-noble metal or a high-melting point metal each containing Ti, Pt, Pd, Ni, Co, Ta, Mo, and W, and in particular, it is a metal or an alloy thereof selected from Ni, Co, Pt or these groups. Since the transfer of the substrate from the cleaning chamber to the sputtering chamber and from the sputtering chamber to the annealing chamber can be performed through a vacuum transfer chamber, the substrate will not be exposed to the atmosphere such that re-oxidation of the substrate surface does not occur while maintaining the roughness of the substrate surface equal to or better than the wet cleaning.

Further, in the above described substrate cleaning method, at the time of turning the plasma gas into plasma, the plasma gas is turned into plasma by applying a high frequency power to the plasma gas, and the high frequency power density is 0.001-0.25 W/cm², preferably 0.001-0.125 W/cm², and more preferably 0.001-0.125 W/cm²_{.}

By the present invention, a substrate process can be performed, which is capable of reducing the native oxide film and organic impurity of the semiconductor substrate surface further than the prior art wet cleaning. Further, the native oxide film and the organic substance can be removed without harming the roughness of the IV group semiconductor surface or the substrate surface doped the impurity such as B, P, and As. To remove the native oxide film and the organic impurity contamination of the substrate surface made of the IV group semiconductor material doped impurity, a mixed gas containing a plasma generation gas and HF or at least a HF gas as a process gas is used, and radical is introduced into the process chamber from the plasma generation chamber, and at the same time, by introducing gas molecules with HF taken as constituent element into the process chamber, the semiconductor substrate surface is exposed to the atmosphere suppressed in excitation energy of the radical, and the native oxide film and the organic substance can be removed without harming the roughness of the substrate surface. Neither the metal contamination of the semiconductor substrate nor the generation of plasma damages occurs. Further, since a series of treatments can be performed in vacuum, the re-oxidation of the substrate surface made of the IV group semiconductor material doped the impurity can be prevented. Further, a contact resistance equal to or lower than the prior art wet process can be obtained. Further, in the prior art wet cleaning, the heating process prior to the deposition is used together, and the substrate treatment requiring a plurality of processes can be managed only by one process, and the predetermined effect can be efficiently obtained, so that the cost can be reduced and the throughput is remarkably enhanced.

Further, the plasma generation gas is provided with a shower plate, thereby enabling the generation gas to be uniformly introduced, and a hole that penetrates the electrode portion is provided, thereby enabling a discharge to be made even at a low electric power, and the radicals in the generated plasma can be uniformly introduced into the process chamber by providing a plasma confinement electrode plate for plasma isolation having a plurality of radical introducing apertures. By realizing the surface treatment having less surface roughness in an atomic layer order, the metal silicide film can be formed in a short period of time, and the contact resistance can be reduced. Further, by performing the substrate surface treatment by a first process and by transferring the metal material film in vacuum by a second process without being exposed to the atmosphere, the impurity of the interface is made fewer than the case of the atmospheric transfer, and because the substrate heating is not used, after the metal material deposition, the metal silicide can be simply formed only by performing the anneal process, and the contact resistance can be reduced. That is, by adopting the dry cleaning of the surface roughness equal to or better than the wet cleaning and the vacuum transfer, a good metal silicide can be formed on the IV group semiconductor substrate doped B or P or As.

### BRIEF DESCRIPTION OF THE DRAWINGS

FIG. 1A is an explanatory drawing of a silicide forming process including wet cleaning;
FIG. 1B is an explanatory drawing of a silicide forming process including dry cleaning;
FIG. 2 is a schematic illustration showing a structural example of a deposition unit used in the present invention;
FIG. 3 is a schematic illustration of a controller installed in a system used in the present invention;
FIG. 4 is a sectional schematic illustration showing a structural example of a surface treatment unit used in the present invention;
FIG. 5A is an expanded sectional view of a plasma confinement electrode plate in the surface treatment unit of the present invention;
FIG. 5B is an expanded view of a plasma confinement electrode plate seen from a process chamber side in the surface treatment unit of the present invention;
FIG. 5C is a schematic illustration showing a structural example of the plasma confinement electrode plate portion of the surface treatment unit used in the present invention seen from the process chamber side;
FIG. 6A is a schematic illustration showing a structural example of a high frequency applying electrode portion of the surface treatment unit used in the present invention;
FIG. 6B is a bird's eye view showing a structural example of the high frequency applying electrode portion of the surface treatment unit used in the present invention;
FIG. 7 is a graph showing a native oxide film/Si in the case where a high frequency power density obtained by an embodiment of the present invention is changed;
FIG. 8 is a schematic illustration showing structural examples of UV, X-ray, and a microwave excitation radical surface treatment unit used in the present invention;
FIG. 9 is a schematic illustration showing a structural example of a catalytic chemical excitation radical surface treatment unit used in the present invention;
FIG. 10A is a schematic illustration showing a surface treatment method used in the prior art;
FIG. 10B is a schematic illustration showing a surface treatment method used in the present invention;
FIG. 11 is a flowchart of a transfer controller program used in the present invention;

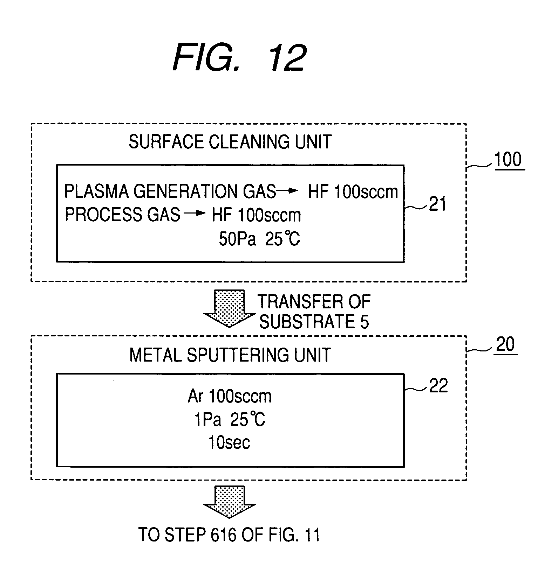

FIG. 12 is a flowchart of a deposition controller program used in the present invention;
FIG. 13 is a graph and a SEM image of the surface showing a surface roughness (Ra) after the substrate treatment obtained by the embodiment of the present invention;
FIG. 14 is a graph showing the surface roughness (Ra) for a process chamber gas ratio in the case where a plasma generation gas ratio obtained by the embodiment of the present invention is changed;
FIG. 15 is a graph showing an atom density of oxygen and carbon obtained by the embodiment of the present invention;
FIG. 16A and FIG. 16B are graphs respectively showing a contact resistance ratio and a deposition time ratio obtained by the embodiment of the present invention, as compared with a conventional wet cleaning;
FIG. 17 is a graph showing an impurity concentration dependency of the surface roughness (Ra) obtained by the embodiment of the present invention;
FIG. 18 is a sectional view of an example of a MOS-FET fabricated by a processing of the present invention;
FIG. 19 is a view of an intra-substrate surface distribution of a silicon oxide film etching rate showing an effect of a gas introduction shower plate toward a plasma chamber of the plasma generation gas of the present invention;
FIG. 20 is a sectional view showing a sputtering deposition chamber forming a metal film on the substrate; and
FIG. 21 is a sectional view showing an annealing chamber for silicification.

### BEST MODES FOR CARRYING OUT THE INVENTION

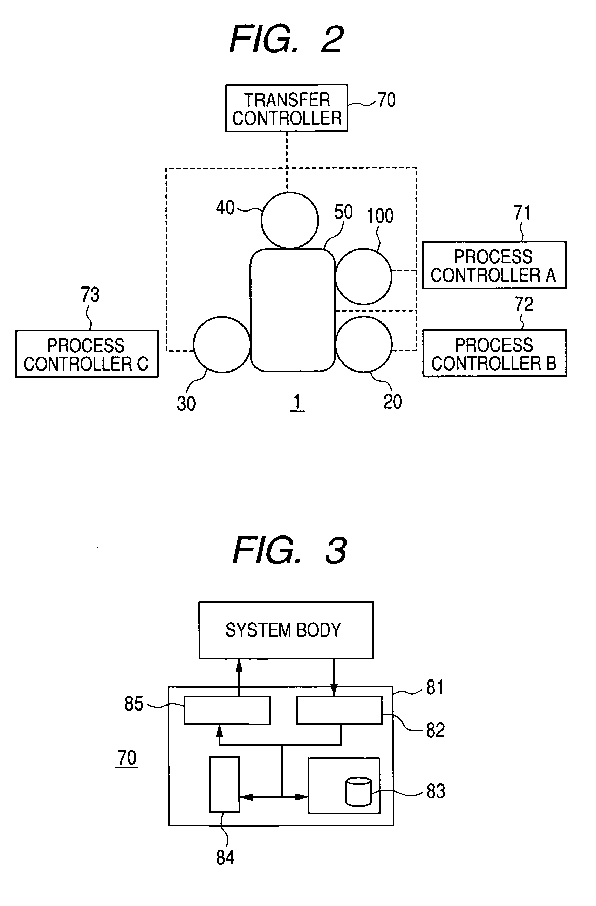

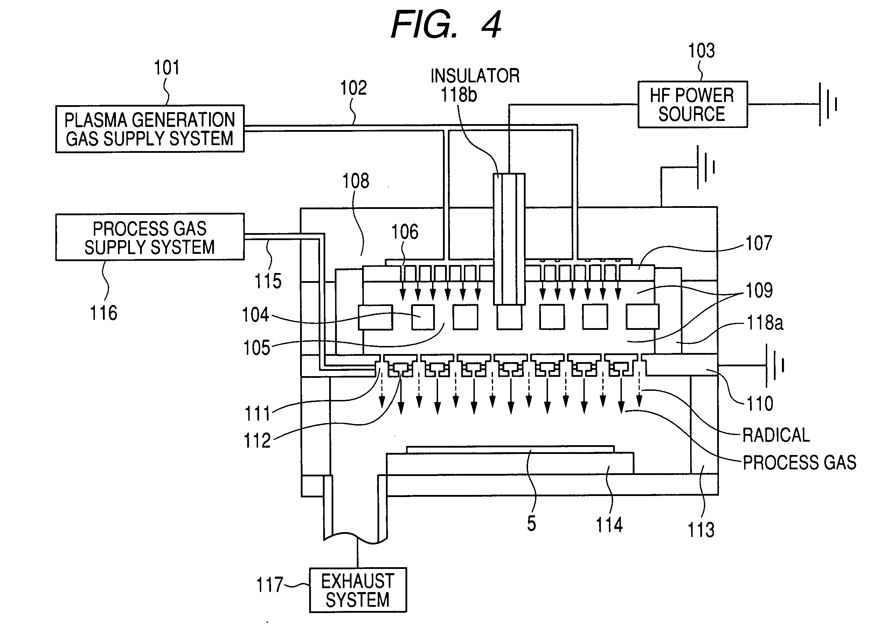

An embodiment of the present invention will be described below.
Hereinafter, the embodiment of the present invention will be described with reference to the accompanied drawings.
In the present embodiment, in a deposition unit 1 shown in FIG. 2, a first process is performed by using a surface treatment unit 100 shown in FIG. 4, and an example applied with the present invention for a process of removing a native oxide film and an organic substance formed on a Si substrate will be described.

A substrate 5 used as a sample is a Si single crystal substrate of 300 mm in diameter exposed to a cleaned air and formed with a native oxide film. The substrate 5 is transferred to a load lock chamber 40 and placed therein by an unillustrated transfer mechanism. Next, the load lock chamber 40 is depressurized by an unillustrated exhaust system. After depressurized to a predetermined pressure, specifically, up to 1 Pa or less, an unillustrated gate valve between the load lock chamber 40 and a transfer chamber 50 is opened, and by an unillustrated transfer mechanism of the transfer chamber 50, the substrate 5 is transferred to the surface treatment unit 100 through the transfer chamber 50, and is placed on a substrate holder 114.

FIG. 4 is an explanatory view of the surface treatment unit 100 of the present invention. The surface treatment unit 100 is composed of a process chamber 113 equipped with a substrate holder 114 capable of loading the substrate 5, and a plasma generation chamber 108. The process chamber 113 and the plasma generation chamber 108 are isolated by a plasma confinement electrode plate 110 for plasma isolation provided with a plurality of radical introducing apertures 111. The plasma generation gas is conveyed by a plasma generation gas supply system 101 and a plasma generation gas supply pipe 102, and is introduced from a plasma generation gas introducing aperture 106 of a plasma generation gas introduction shower plate 107 to a plasma generation space 109 of the plasma generation chamber 108. Thereby, the plasma generation gas can be uniformly introduced to the plasma generation space 109 of the plasma generation chamber 108.

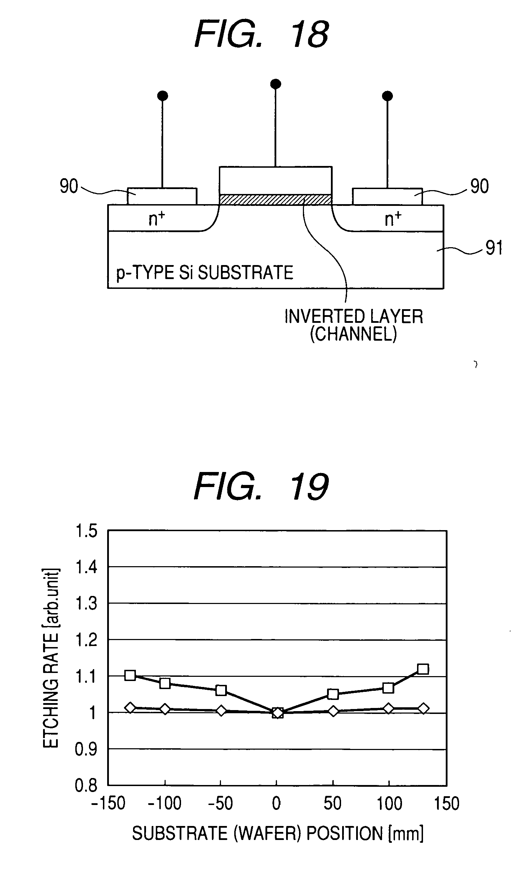

FIG. 19 is a view explaining the effect of the plasma generation gas introduction shower plate 107 in the present embodiment. As the plasma generation gas, a HF gas is used 100 sccm, and under the conditions of a high frequency power density of 0.01 W/cm² and a process chamber pressure of 50Pa, a silicon oxide film etching rate of the substrate placed in the process chamber is measured. In FIG. 19, an horizontal axis shows measurement position in substrate , and an vertical axis shows an etching rate of the silicon oxide film normalized by the etching rate of the center. As shown in FIG. 19, when a comparison is made between a case 901 that uses the plasma generation gas introduction shower plate and a case 902 that performs the introduction from a lateral direction not using the shower plate which is the prior art introduction method, the case 901 that performs the introduction by the shower plate is better in etching rate intra-surface uniformity. This is presumed due to the fact that the uniform gas introduction to the plasma generation space 109 enables the distribution of uniform active species concentration to be obtained in the plasma generation space 109 and this is reflected. Consequently, this proves that, by an effect enhanced by the uniform plasma generation by a through-hole 105 of the high frequency applying electrode 104 to be described later, the radical supply introduced to the process chamber becomes more uniform.

The high frequency applying electrode 104 is extended along the plasma generation gas introduction shower plate 107 so as to divide the plasma generation chamber 108 into upper and lower two zones, and along the lower plasma confinement electrode plate 110 for plasma isolation. The plasma generation gas introduction shower plate 107 is connected to an earth (grounded). Although the shower plate is conductive, it may be formed by an insulating material, and in this case, a grounded electrode may be located at a place positioned at the back side of the shower plate seen from the plasma generation space 109. Further, the high frequency applying electrode 104 is provided with the through-hole 105. The high frequency power is applied to the high frequency applying electrode 104 by a high frequency power source 103, thereby to generate plasma.

The plasma confinement electrode plate 110 for plasma isolation has a function of the plasma confinement electrode plate 110 for plasma isolation that divides the plasma generation chamber 108 and the process chamber 113. This plasma confinement electrode plate 110 is provided with radical introducing apertures 111 that block off ions in plasma inside the plasma chamber and allows radicals to pass through the process chamber 113.
The plasma confinement electrode plate 110 for plasma isolation is formed in a hollow structure, and is provided with a plurality of process gas introducing apertures 112 opened at the process chamber 113 side.
The plasma confinement electrode plate 110 for plasma isolation is made of a conductive material, and is connected to an earth (grounded). By supplying the process gas to this hollow structure, a structure capable of uniformly supplying the process gas to the process chamber 113 from the plurality of process gas introducing apertures 112 opened to the process chamber 113 side is provided. The process gas introducing aperture 112 is opened in the vicinity of the radical introducing aperture 111. The process gas is conveyed from a process gas supply system 116 through a process gas supply pipe 115, and is introduced into the process chamber 113 from the plurality of process gas introducing apertures 112 opened at the process chamber 113 side. The radical derived from the plasma generation gas introduced from the radical introducing aperture 111 and the molecule of the process gas introduced from the process gas introducing aperture 112 are mixed for the first time inside the process chamber 113, and are supplied to the surface of the substrate 5.

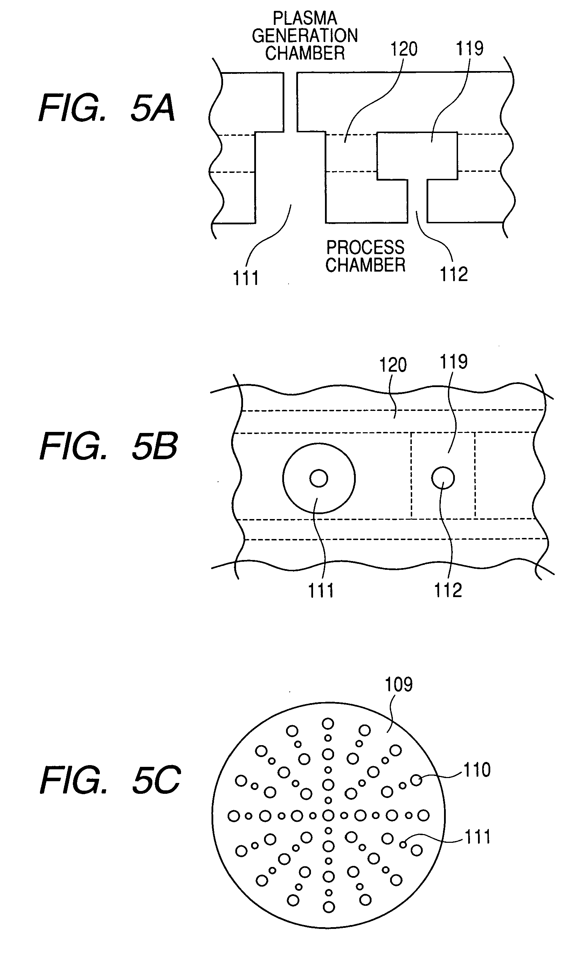

As described above, radicals derived from the plasma generation gas are introduced to the process chamber 113 from the radical introducing apertures 111 provided in the plasma confinement electrode plate 110 that isolates the process chamber 113 and the plasma generation chamber 108. Here, those introduced into the process chamber 113 by passing through the radical introducing apertures 111 of the plasma confinement electrode plate 110 from the plasma generation chamber 108 are electrically neutral molecules or atoms such as radicals, and ions in the plasma are scarcely introduced to the process chamber 113. In the plasma generation chamber 108, when ion density is approximately 1 × 10¹⁰ pcs/cm³, the ion density in the process chamber 113 is approximately 5 × 10² pcs/cm³, so that the ion density is really reduced to not more than one-hundred millionth, and it can be said that the ions introduced into the process chamber 113 are practically hardly available. In contrast to this, the radicals, though depending on their life spans, of approximately several to several tens percent from among those generated in the plasma generation chamber are conveyed to the process chamber 113. FIGS. 5A and 5B are sectional views and expanded top plan views of the plasma confinement electrode plate 110, wherein the process gas is exhausted to a process gas exhaust chamber 119 provided for each process gas introducing aperture 112 from a passage 120 that sends the process gas in a transversal direction of the electrode plate 110. The process gas is supplied to the process chamber through the introducing aperture 112 from the exhaust chamber 119. FIG. 5C is a whole top plan view of the whole of the plasma confinement electrode plate 110.

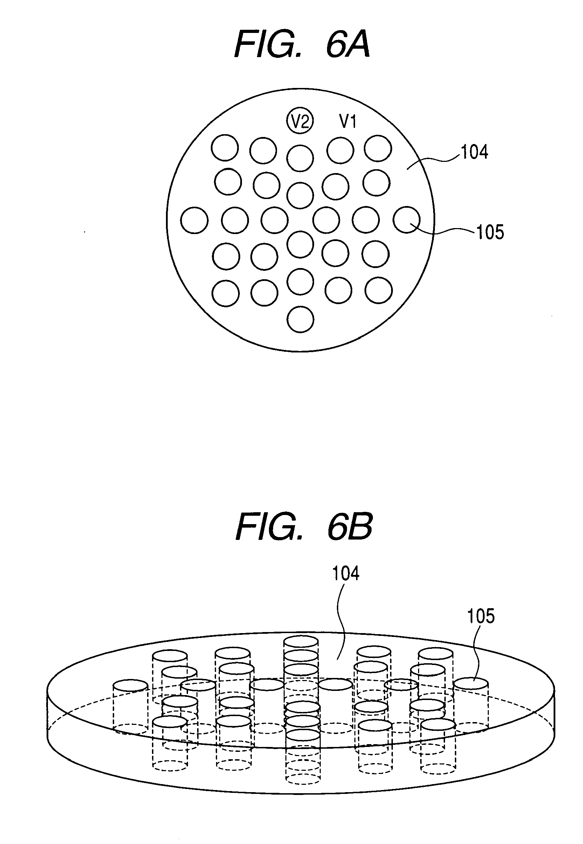

The through-hole 105 of the high frequency applying electrode 104 uses the one having a shape as shown in FIGS. 6A and 6B. By this electrode through-hole 105, the electrode can more uniformly discharge at even a low power of 0.25 W/cm² or less, and therefore, the radicals can be uniformly introduced into the process chamber 113. A volume ratio of an overall volume V1 of the high frequency applying electrode 104 including the electrode trough-hole 105 to a volume V2 of the electrode through-hole 105 is preferably V2/V1 = 0.01 to 0.8, and in case of V2/V1 < 0.01, deterioration of the radical distribution is confirmed. Further, in case of V2/V1 > 0.8, a discharge is unable to be performed.

Next, a manufacturing method of the semiconductor element using the deposition unit 1 of FIG. 1 of the present invention will be described.
First, a substrate treatment process and its condition of a first process will be described. The unit used in the first process is the surface treatment unit 100 shown in FIG. 4.
As a plasma generation gas, HF is supplied 100 sccm to the plasma generation chamber 108, and plasma is generated in the plasma generation portion, and radicals in the generated plasma are supplied to the process chamber 113 through the radical introducing apertures 111 formed in the plasma confinement electrode plate 110 for plasma isolation provided with a plurality of radical introducing apertures 111. To suppress the excitation energy of the radicals, HF is supplied 100 sccm as the process gas to the process chamber 113 from the process gas introducing aperture 112. The high frequency power density for the plasma generation is taken as 0.01 W/cm², the pressure as 50 Pa, a processing time as 5 min, and the temperature of the substrate 5 as 25°C.

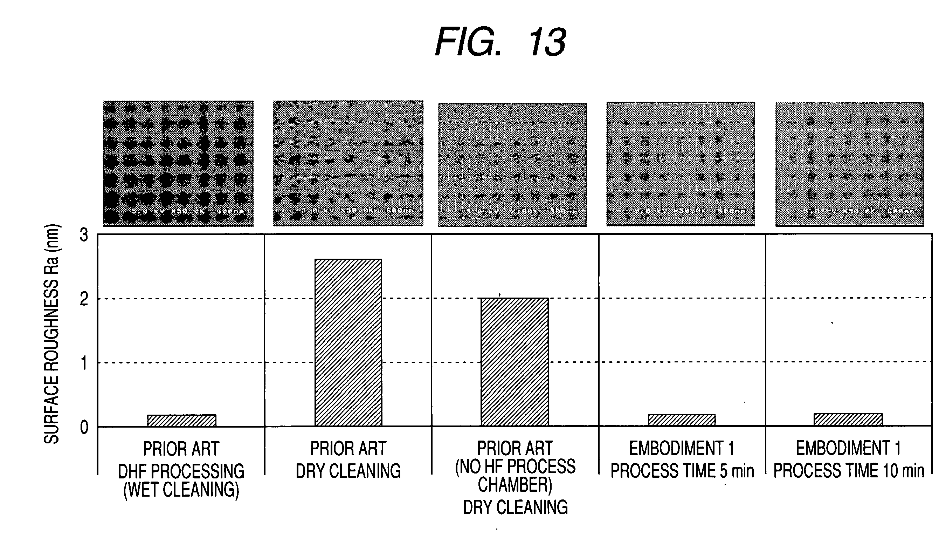

FIG. 13 shows that a surface roughness after the first process of the present invention is checked, which is compared with the result of the prior art dry process and the wet process. As shown in FIG. 13, the surface roughness Ra obtained by using the first process of the present invention includes a surface roughness Ra approximately equivalent to 0.18 nm, which is not more than 0.5 nm, and a surface roughness Ra of 0.17 nm when the wet treatment (wet cleaning) is performed by a diluted fluorinated acid solution, thereby obtaining the good surface roughness equal to each other. Further, when the HF gas is not supplied to the process gas, the surface roughness Ra is larger than 0.5 nm, and is roughened to 2.00 nm. Further, even when the process time is extended to 10 min, it is confirmed that the surface roughness Ra is not roughened to 0.19 nm. The reason why the surface roughness is improved is because the surface native oxide film and the organic substance are selectively removed for Si. By allowing HF having high excitation energy generated by plasma to collide with unexcited HF introduced separately as a process gas, HF suppressed in excitation energy is generated.
This is presumed to selectively remove the surface native oxide film without etching Si atoms of the surface. From these results, it is confirmed that, by using the present invention, the surface roughness equivalent to the wet cleaning can be realized in the dry cleaning without requiring high temperature pretreatment.

The surface roughness in the present invention becomes better if HF suppressed in excitation energy is generated by allowing HF having high excitation energy generated by plasma to collide with the unexcited HF introduced separately as a process gas. Consequently, if this surface roughness is in a realizable state, it is not limited to the configuration of the present embodiment.

That is, in the present embodiment, the radicals generated by plasma are supplied to the substrate through the radical introducing apertures 111 which are the plurality of through-holes located at the plasma containment electrode plate 110, while the process gas is supplied at the same time from the plurality of process gas supply holes provided on the electrode plate. However, to obtain the smoothed surface roughness, such a structure is not always required, and this can be realized by turning the gas containing the HF gas into plasma, introducing to the process chamber 113 active species only excited by an unit capable of blocking off the majority of ions and transferring neutral active species only, and further introducing the HF gas unexcited from any place of the process chamber 113.
However, from a view point of the uniformity, above all when it is necessary to perform a uniform process for the substrate of a large diameter, both of the radical and the unexcited process gas have to be uniformly supplied to the substrate. Hence, a structure similarly to the present embodiment is preferable in which the radicals are shower-supplied from the electrode plate at a position opposed to the substrate, and further, at the same time, the process gas can be shower-supplied.

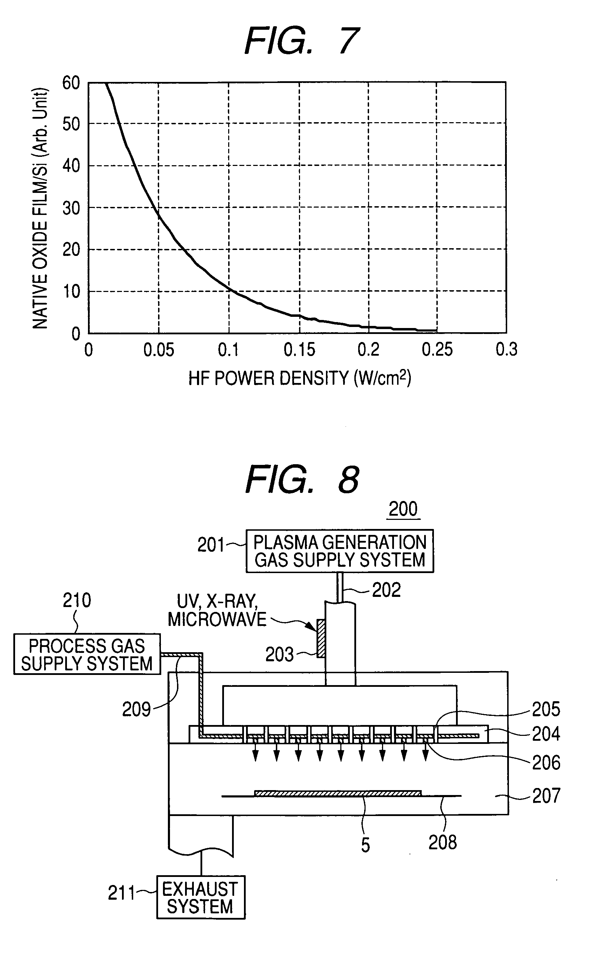

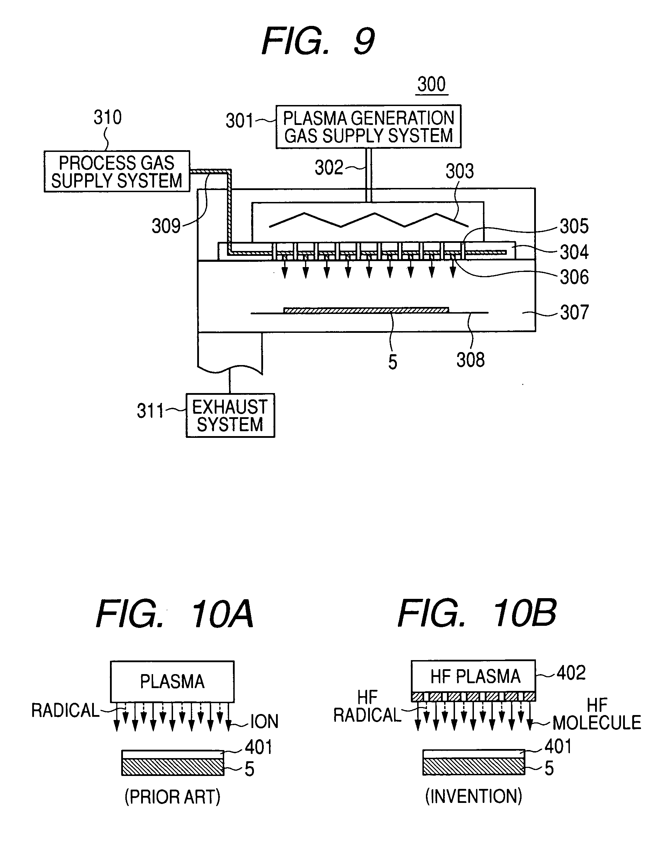

While the radical generation in the present embodiment is performed by the plasma generation by applying the high frequency, it may be performed by the plasma generation by microwave and other method, and specifically, it may be performed by UV, X-ray, and microwave excitation shown in FIG. 8 and catalytic chemical excitation shown in FIG. 9. In FIG. 8, UV, X-ray, and microwave are irradiated at the plasma gas from the introduction chamber 203 so as to turn the plasma gas into plasma, wherein reference numeral 5 denotes a substrate, numeral 201 a plasma generation gas supply system, numeral 202 a plasma gas generation supply pipe, numeral 204 a plasma confinement electrode plate for plasma isolation provided with a plurality of radical introducing apertures, numeral 205 a radical introducing aperture, numeral 207 a process chamber, numeral 208 a substrate holder, numeral 209 a process gas supply pipe, numeral 210 a process gas supply system, and numeral 211 an exhaust system. The process gas system has the same structure as that of FIG. 4.
FIG. 9 is a view of the structure turning the gas into plasma by a heated catalyst body 303, wherein reference numeral 5 denotes a substrate, numeral 301 a plasma generation gas supply system, numeral 302 a plasma generation gas supply pipe, numeral 304 a plasma confinement electrode plate for plasma isolation provided with a plurality of radical introducing apertures, numeral 305 a radical introducing aperture, numeral 306 a process gas introducing aperture, numeral 307 a process chamber, numeral 308 a substrate holder, numeral 309 a process gas supply pipe, numeral 310 a process gas supply system, and numeral 311 an exhaust system. The process gas system has the same structure as that of FIG. 4.

The plasma generation gas introduced into the plasma generation chamber uses HF only in the present embodiment. However, it may contain at least HF, and specifically, the HF gas diluted by Ar may be used. Plasma is generated, and is made to pass through the plasma containment electrode plate 110, so that radical is introduced into the process chamber 113. Further, the process gas introduced into the process chamber 113 uses HF only in the present embodiment. However, it may contain at least HF, and specifically, the HF gas diluted by Ar may be used. The radical introduced into the process chamber 113 from the radical introducing aperture 111 of the plasma containment electrode plate 110 and the process gas introduced from the process gas introducing aperture 112 are mixed, thereby an atmosphere suppressed in excitation energy of the radical is created, and the native oxide film and the organic substance of the substrate surface are selectively removed for Si serving as a substrate, thereby the substrate surface treatment can be performed, while suppressing the surface roughness.

A ratio of HF to a total gas flow rate is preferably 0.2 to 1.0 in view of the surface roughness after the surface treatment. The experimental result confirming this point will be described as follows.

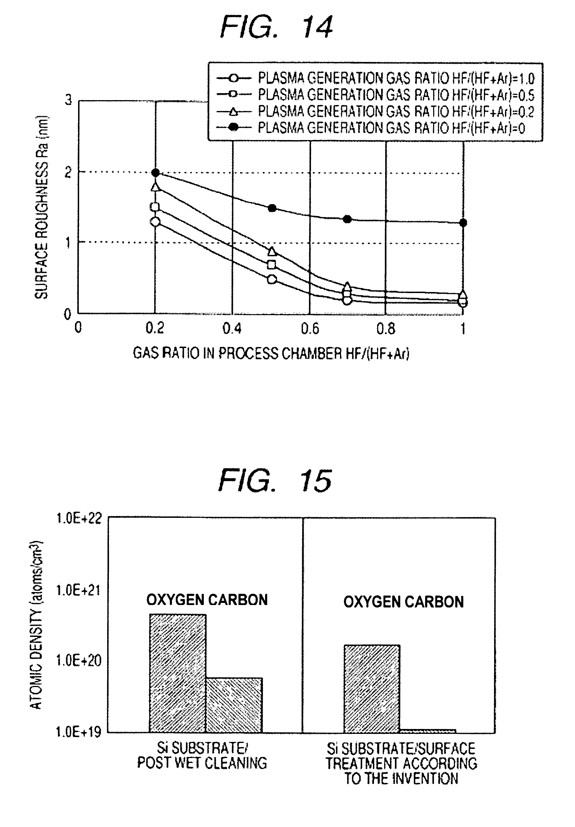

FIG. 14 shows a HF mixing ratio dependence of the surface roughness when a mixed gas of HF and Ar is used for the plasma generation gas and the process gas. As shown in FIG. 14, by changing a mixing ratio of HF and Ar of the process gas, the surface roughness after the removal of the native oxide film is changed. By increasing a flow rate of the HF gas, the surface roughness can be decreased. Even when the HF gas is used as the plasma generation gas supplied to the plasma generation chamber 108 and the radicals are supplied through the radical introducing apertures 111 which are formed in the plasma confinement electrode plate 110 for plasma isolation provided with a plurality of radical introducing apertures 111, in case the process gas is Ar only, the native oxide film on the substrate surface cannot be removed, and an object of the surface treatment is not achieved. Further, when a check is made on the case where the HF gas is used as the plasma generation gas and no gas is let flow as the process gas, the surface roughness Ra becomes 2.5 nm, and is deteriorated as compared with the case where HF is let flow. Further, as shown in FIG. 14, when the HF ratio HF/(HF+Ar) of the plasma generation gas is 0, that is, the plasma generation gas is only Ar, the roughness does not become good as compared with the case where the plasma generation gas includes HF. In the desired surface roughness where the contact resistance is made sufficiently small, to have the surface roughness made equivalent to approximately 0.5 nm or less of the wet cleaning, the process chamber gas ratio HF/(HF+Ar) is required to be 0.6 or more. Further, in the present embodiment, though the Si substrate is used, the substrate surface treatment of the present invention is not limited to the surface treatment of the Si substrate. Specifically, the surface of the substrate may be formed of the IV group semiconductor such as Si and SiGe, and more specifically, it may be the one which is adhered on a glass substrate or applicable to the substrate surface treatment such as the removal of the native oxide film and the organic contaminants of the surface of the IV group semiconductor such as a laminated thin Si layer.
The high frequency power density applied to the high frequency applying electrode 104 is preferably 0.001-0.25 W/cm².

FIG. 7 is a graph showing a high frequency power density dependency of the native oxide film/Si which is an etching rate of the native oxide film and Si in the case where HF is used for the plasma generation gas and HF is used for the process gas. By decreasing the high frequency power density, the etching of Si is suppressed, and the native oxide film only is selectively etched. Here, a value dividing the etching rate of the native oxide film by the etching of Si is taken as native oxide film/Si. When the high frequency power density is minimized, the etching rate of Si is relatively reduced, so that the native oxide film /Si is increased. On the other hand, when the high frequency power density is increased, the etching of Si prominently occurs, and the native oxide film/Si is reduced. Here, when the high frequency power density increases, the etching of Si occurs, and therefore, the surface is roughened. To reduce the roughness of the surface, it is necessary that the native oxide film/Si is increased and the high frequency power density is minimized. For this reason, the high frequency power density is selected within a range of the 0.001-0.25 W/cm², preferably 0.001-0.125 W/cm², and more preferably 0.001-0.025 W/cm².

Next, a metal material sputtering process and its condition of a second process will be described.
A process will be described in which, by using the deposition unit 1 shown in FIG. 2, a first process using the surface treatment unit 100 shown in FIG. 4 is performed, thereby to remove the native oxide film formed on the Si substrate, and after that, the substrate is transferred to the metal sputtering unit 20 performing the second process through the vacuum transfer chamber 50, and the metal material is sputter-deposited on the surface after the surface treatment process. Here, the metal material is preferably a noble metal, a semi-noble metal or a high-melting point metal containing Ti, Pt, Pd, Ni, Co, Ta, Mo, and W. The most preferable metal is Ni, Co, Pt or a metal mixing these elements.

The surface treatment is performed by the first process, and by the semiconductor element manufacturing unit inside the metal sputtering unit 20 that performs the second process, Ar is supplied 100sccm at the substrate temperature 25°C with DC power 1.5 kW, and the pressure is held at 1 Pa, and a Ni target is processed for ten seconds. As a result, as shown in FIG. 15, comparing with the case where the Ni sputtering deposition is performed after performing the wet cleaning, an atom density of oxygen and carbon at the interface between the Si substrate and the Ni sputtering film is lower in the present embodiment. Specifically, the atom density of oxygen and carbon at the interface is 2 × 10²⁰ atoms/cm³ or less. This is because, by performing vacuum transfer without exposing the surface after the substrate cleaning to the atmosphere, absorption of the impurities of oxygen and carbon to the surface can be suppressed. In the process of sputtering the metal material in the metal sputtering unit 20, the target can be replaced by another material, which is preferably a noble metal, a semi-noble metal or a high-melting point metal containing Ti, Pt, Pd, Ni, Co, Ta, Mo, and W. The most preferable metal is Ni, Co, Pt or a metal mixing these elements. The metal material deposition in the second process may be performed by CVD in addition to sputtering.

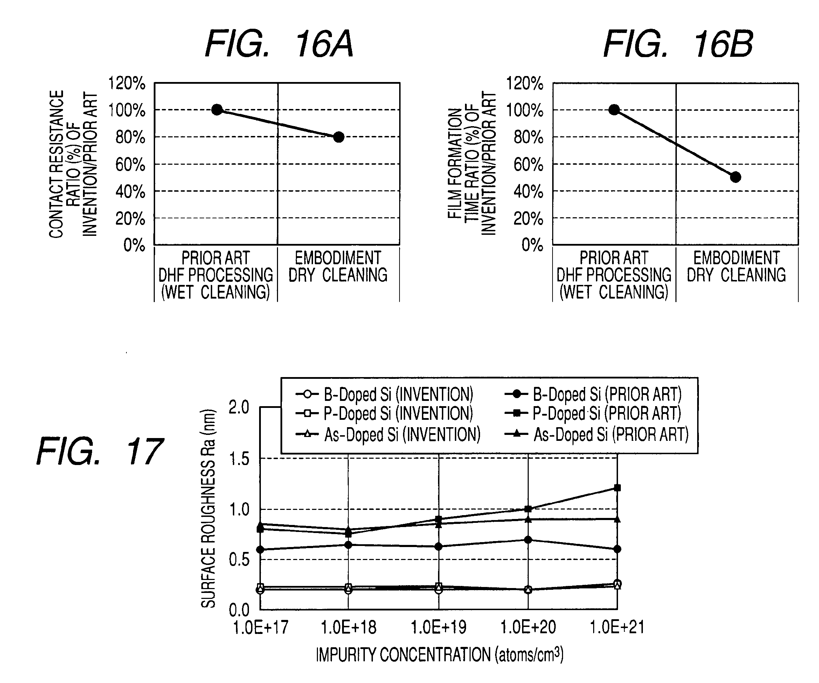

A metal silicide process of a third process will be described.
After the second process, the substrate is held at the substrate temperature 250°C for 10 min by the semiconductor element manufacturing unit inside the annealing unit 30 through the transfer chamber 50, thereby performing metal silicide formation. As a result, a Ni2Si layer is formed. The units 10 to 50 are controlled by respective transfer or process controllers 70 to 73. FIG. 16A and FIG. 16B show respectively comparisons between a contact resistance of a metal silicide film to a substrate and a process time up to the formation of the metal silicide layer, fabricated by the present invention and the prior art (when the wet cleaning is performed in replace of the first process). As compared with the prior art, the contact resistance is reduced by 20%, and the silicide formation time is shortened by 50%. This reduction of the contact resistance is because the surface impurities of oxygen and carbon on the Si surface deposited by the second process after the substrate cleaning of the first process are few. That is, this is due to the effect of a series of vacuum processes after the dry cleaning. Further, the shortening of the silicide formation time is due to the effect of a series of vacuum processes that include no atmospheric transfer between each process since the cleaning, the metal material sputtering, and the annealing are all performed by one unit only. Further, the reason why there is no need to mange the transfer time between each process in the manufacturing process as compared with the prior art is due to the effect of a series of vacuum processes that include no atmospheric transfer between each process. Further, the surface treatment that requires a plurality of processes can be performed in one process, and the predetermined effect can be efficiently obtained, so that the cost can be also reduced and throughput can be improved to a large extent.

FIG. 17 shows a result of having performed the surface treatment of the present invention for the substrate surface doped B or P or As on Si in each density. The conditions of the surface treatment of the present invention in FIG. 17 are applicable to the case where HF only (HF/(HF+Ar) = 1.0) is used for the plasma generation gas and HF only (HF/(HF+Ar) = 1.0) is also used for the process gas. Further, the prior art in FIG. 17 indicates the dry cleaning, and is applicable to the case where HF is not used for the plasma generation gas, but Ar only is used (HF/(HF+Ar) = 0), and HF only (HF/(HF+Ar) = 1.0) is used for the process gas. In the prior art, when B or P or As is doped, the surface roughness is larger than 0.5 nm, and in the case of P, the concentration dependency is found, whereas when the surface treatment of the present invention is performed, the surface roughness is 0.5 nm or less, and does not depend on the impurity concentration, and moreover, the roughness is improved further than the prior art. This shows that the surface treatment of the present invention is high in selectivity with the native oxide film and the surface material. In FIG. 18 is shown an example of the structure of MOS-FET containing a metal silicide film 90 fabricated by using the present invention. An electrode portion of the metal silicide film 90 is formed on an n⁺ silicon region doped P or As.
When B is doped, the electrode portion of the metal silicide film 90 is formed on the p⁺ silicon region.

The deposition unit 1 of FIG. 2 is provided with a controller for performing a series of processes by a series of vacuum processes for each process unit and transfer unit. That is, the transfer controller 70 is enabled to receive an input signal from the unit at an input portion and operate a transfer program that is programmed to work by a flowchart by a processor, and output an operating instruction for the transfer of the substrate to each process unit through a vacuum transfer. Further, process controllers A to C (71 to 73) are enabled to receive the input signal from the process unit, operate a program that is programmed to operate the process by the flowchart, and output an operating instruction to the unit. The configurations of the controller 70 and the process controllers 71 to 73 basically carry the configuration of the computer 81 shown in FIG. 3, and are formed of an input portion 92, a memory medium 83 having the program and data, a processor 84, and output portion 85, and controls the corresponding unit. The input portion 82 can input commands from the outside in addition to the data input function from the unit.

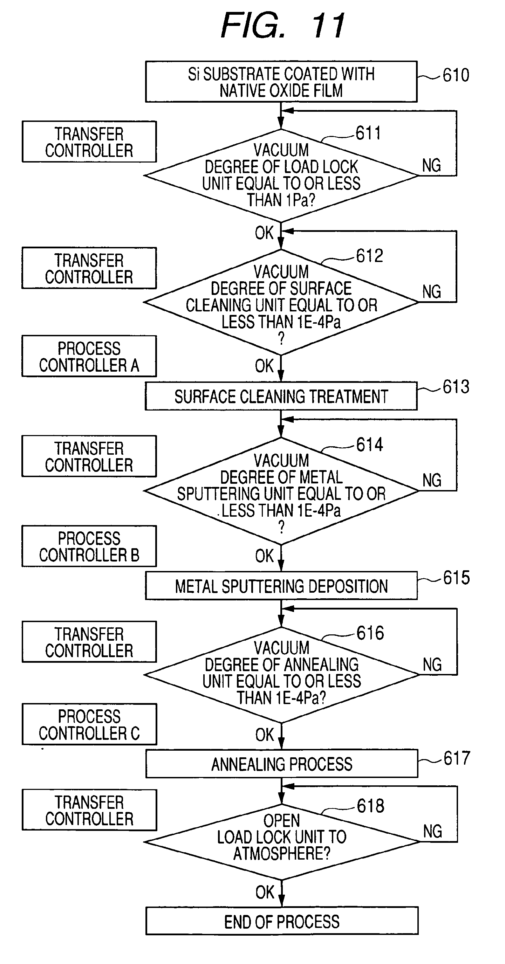

In FIG. 11 is shown the controls performed by the transfer controller 70 and the process controllers A to C (71 to 73). At step 610, the Si substrate coated with the native oxide film is prepared. The transfer controller 70 gives instructions to the effect that a vacuum degree of the load lock unit 40 is set equal to or less than 1Pa (step 611), and further gives instructions to the effect that a degree of vacuum of the surface treatment unit 100 is set to equal to or less than 1E-4Pa, and moves the substrate S into the surface treatment unit 100 through the transfer chamber 50 and mounts the substrate S on a substrate holder. The process controller A71 controls a procedure of performing the surface treatment of the first process on the substrate 5 (step 613).
The transfer controller 70 performs a control of vacuum exhausting so as to set a degree of vacuum of the metal sputtering unit 20 equal to or less than 1E-4Pa, and installs the substrate 5 inside the surface treatment unit 100 into the metal sputtering unit 20 through the transfer chamber 50. The process controller B72 performs a control of performing a sputtering deposition process of the metal material of the second process inside the metal sputtering unit 20 (step 615). Immediately after that, to perform the annealing process of the third process, the metal material is moved into the annealing unit 30 through the transfer chamber 50 (Step 616). The process controller C73 performs a control of performing the thermal treatment in order to silicify the metal material of the third process inside the annealing unit 30 (Step 617). After that, the transfer controller 70 opens the load lock unit 40 to the atmosphere (Step 618).

While the deposition unit of the present invention, as shown in FIG. 2, employs a configuration made of one each of the surface treatment unit 100, the metal sputtering unit 20, the annealing process unit 30, the load lock chamber 40, the transfer chamber 50, each unit is not necessarily to be made of one each only, and it does not matter if a plurality of units are used for the configuration of the throughput and the film. For example, the load lock may be replaced by a plurality of load locks having a divided function of loading and unloading in order to increase the throughput. Further, for example, the metal sputtering unit 20 may be replaced by two or more sputtering units of a unit for forming the metal material and a unit for forming the electrode.

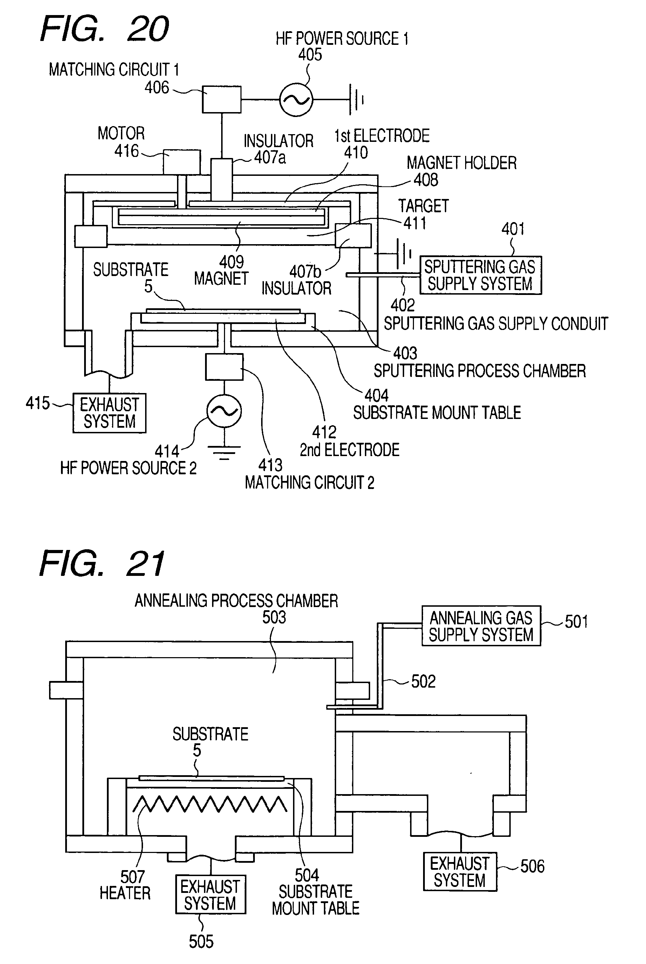

However, to efficiently employ the substrate treatment method capable of performing a dry substrate surface treatment, while maintaining a flat surface of the present invention, it is preferable that at least one or more of the surface treatment unit 100, the metal sputtering unit 20, the annealing process unit 30, the load lock chamber 40, and the transfer chamber 50 are provided. This is because, being configured in this manner, the dry substrate surface treatment can be performed in a pressure reduction status of a stable atmosphere due to the presence of load lock and by high throughput, and without being carried out into the atmosphere, the substrate is transferred in vacuum to the metal sputtering deposition unit through the transfer chamber, wherein the deposition is performed such that the substrate surface and the interface subjected to the metal sputtering deposition are maintained in a good state, thereby to reduce the contact resistance by lowering the resistance. The outline of the cross section of the sputtering unit used in the present embodiment is shown in FIG. 20.

The sputtering unit 20 in FIG. 20 is formed of a first electrode 410, a target member 411, a second electrode 412, and a substrate mount table 404. The target member 411 is provided on the surface of the first electrode 410. A magnet 409 is at the back of the target member 411 and is provided between the first electrode 410 and the target member 411. Further, the sputtering unit 20 includes a sputtering gas supply system 401, a sputtering gas supply pipe 402, and an exhaust system 415. The sputtering gas can supply Ar, Kr, Xe, He or the gas mixing these gases. The first electrode 410, for example, is made of a metal such as Al (aluminum), and is placed on an insulator 407b fabricated by dielectric substance, for example, ceramics. Further, the side face of the sputtering process chamber is electrically grounded. The target member 411 is made of a metal, which is preferably a noble metal, a semi-noble metal or a high-melting point metal containing Ti, Pt, Pd, Ni, Co, Ta, Mo, and W.

The most preferable metal is Ni, Co, Pt or a metal mixing these elements. The target member is sputtered, and is laminated on the surface of the substrate 5. This substrate 5 is placed on the second electrode 412 provided in the substrate mount table 404. The target member 411 is firmly fastened to the first electrode 410, for example, by bolt, diffusion bonding, and the like, and can be efficiently fed from the electrode. A magnet holder 408 can be rotated around a central axis of the first electrode 410. The magnet may be of an integral-type, and may be provided with a plurality of magnets. To rotate the magnet holder 408, it is connected to a motor 416. The first electrode 410 is connected to a high frequency power source 405 through a matching circuit 406. The second electrode 412 is connected to a high frequency power source 414 through a matching circuit 413. A sputtering cathode for installing the target of the sputtering unit 30 need not be one only. To deposit a plurality of films that are continuous or not continuous, a plurality of sputtering cathodes for installing a plurality of targets may be provided. Further, in view of the uniformity of deposition distribution, the substrate holder is preferably provided with a rotating mechanism for rotating the substrate placed on the substrate holder. Further, in order to be able to perform the deposition by the reactive sputtering, a gas introduction mechanism of the sputtering unit 30 can introduce not only the inactive gas such as Ar, but also the reactive gas such as N₂ and O₂ or the mixed gas of these reactive gas and Ar gas.
Next, an outline of the cross section of the annealing unit used in the present embodiment is shown in FIG. 21. The annealing unit 30 in FIG. 21 is formed of a substrate mount table 504 and a heater 507. Further, the annealing unit 30 includes an annealing gas supply system 501, an annealing gas supply pipe 502, and exhaust systems 505 and 506. Annealing can supply Ar, Kr, Xe, He, N2, H2 or the gas mixing these elements. The substrate mount table 504 is heated by radiation heat of a heater, and further, the substrate 5 is heated by the radiation heat from the substrate mount table 504. The temperature of the substrate is approximately 20°C when the heating is not performed, while it can be heated up to 30°C to 1000°C by performing the heating.

## Claims

1. A method of forming a metal silicide layer on a substrate surface made of a IV group semiconductor material doped an impurity of B or P or As, comprising:
turning a plasma generation gas containing HF into plasma inside a plasma generation chamber, and selectively introducing radical in the plasma into a cleaning chamber from the plasma generation chamber, and introducing a process gas containing an unexcited HF in a gas ratio of 0.6 or more into the cleaning chamber thereby cleaning the substrate in the mixed atmosphere of the radical and the process gas;
transferring the cleaned substate from the cleaning chamber to a sputtering chamber without the cleaned substrate being exposed to the atmosphere, and growing a metal sputtering layer made of a metal material on the cleaned substrate surface inside the sputtering chamber; and
transferring the substrate having the metal sputtering layer from the sputtering chamber to an annealing chamber without the substrate being exposed to the atmosphere, and modifying the metal sputtering layer of the substrate surface into silicide by heating thereon inside the annealing chamber.

2. The method according to claim 1, wherein the roughness of the substrate surface after the cleaning is 0.5 nm or less.

3. The method according to claim 1, wherein said metal sputtering layer is a noble metal, a semi-noble metal or a high-melting point metal each containing Ti, Pt, Pd, Ni, Co, Ta, Mo, and W, and in particular, it is a metal or an alloy thereof selected from Ni, Co, Pt or these groups.

4. The method according to claim 1, wherein at the time of turning the plasma gas into plasma, the plasma gas is turned into plasma by applying a high frequency power to the plasma gas, and the high frequency power density is 0.001-0.25 W/cm², preferably 0.001-0.125 W/cm², and more preferably 0.001-0.025 W/cm².

5. The method according to claim 1, wherein the transfer of the substrate from a cleaning chamber to a sputtering chamber, and from the sputtering chamber to an annealing chamber is performed through a vacuum transfer chamber connected to the cleaning chamber, the sputtering chamber and the annealing chamber by a gate valve.

6. A silicide film forming apparatus comprising computer storage medium for storing a program, the program issuing instructions for allowing a computer to control the formation of a silicide film, wherein program for executing a forming process of the silicide film is made of a program for executing the following processes (a) to (c):
(1) a process of cleaning a substrate surface made of the IV group semiconductor material doped an impurity of B or P or As,
wherein the cleaning of the substrate surface is performed by turning a plasma generation gas containing HF into plasma inside a plasma generation chamber, and selectively introducing radical in the plasma into a cleaning chamber from the plasma generation chamber, and at the same time, introducing a process gas containing unexcited HF in a gas ratio of 0.6 or more into the cleaning chamber, thereby performed in the mixed atmosphere of the radical and the process gas,
(2) a process of transferring the cleaned substrate from the cleaning chamber to a sputtering chamber without the cleaned substrate being exposed to the atmosphere, and growing a metal sputtering layer made of a metal material on the cleaned substrate surface inside the sputtering chamber, and
(3) a process of transferring the substrate having the metal sputtering layer from the sputtering chamber to an annealing chamber without the substrate being exposed to the atmosphere, and modifying the metal sputtering layer of the substrate surface into silicide by heating thereon inside the annealing chamber.
